## Europäisches Patentamt
## European Patent Office
## Office européen des brevets

(19)

(11) Veröffentlichungsnummer: **0 301 567**
**A2**

(12) **EUROPÄISCHE PATENTANMELDUNG**

(21) Anmeldenummer: **88112314.5**

(22) Anmeldetag: **29.07.88**

(51) Int. Cl.⁴: **C23C 16/44 , C23C 16/54 , C23C 16/56**

(30) Priorität: **30.07.87 DE 3725358**

(43) Veröffentlichungstag der Anmeldung: **01.02.89 Patentblatt 89/05**

(84) Benannte Vertragsstaaten: **CH DE FR GB LI NL**

(71) Anmelder: **Telog Systems GmbH Fraunhoferstrasse 11 D-8033 Martinsried(DE)**

(72) Erfinder: **Hokynar, Jiri Fraunhoferstrasse 11 D-8033 Martinsried(DE)**

(74) Vertreter: **Geissler, Bernhard, Dr. jur., Dipl.-Phys. Patent- und Rechtsanwälte et al Bardehle-Pagenberg-Dost-Altenburg-Frohwitter-Geissler & Partner Postfach 86 06 20 D-8000 München 86(DE)**

(54) **Vorrichtung und Verfahren zur Oberflächenbehandlung von Materialien.**

(57) Eine Vorrichtung und im Verfahren zur Beschichtung von elektronischen Elementen insbesondere Halbleiter-Wafers, Leiterplatten und dgl. werden vorgeschlagen, wobei die Führung des gasförmigen Beschichtungsmaterials derart eingestellt wird, daß eine Verunreinigung der Elemente durch abgelagerte Reste in dem Reaktionsrohr aus Vorangegangen Beschichtungsvorgängen weitgehend vermindert wird. Außerdem wird eine integrierte Vorrichtung zur Reinigung der Beschichtungsvorrichtung mit Hilfe eines Plasmas geschaffen. Bei dem Reinigungsverfahren wird ein mit Mikrowellen erzeugtes Plasma in das Reaktionsrohr eingelassen und die Innenflächen des Reaktionsrohres werden durch trockenes Ätzen gereinigt.

EP 0 301 567 A2

## Vorrichtung und Verfahren zur Oberflächenbehandlung von Materialien

Die Erfindung betrifft eine Vorrichtung und ein Verfahren zur Behandlung von Materialoberflächen, insbesondere eine Beschichtungs-Vorrichtung und ein Verfahren zur Beschichtung von elektronischen Elementen wie Halbleiter-Wafers, Leiterplatten und dergleichen, sowie eine integrierte Vorrichtung und ein Verfahren zur Reinigung der Beschichtungs-Vorrichtung.

Bei der Beschichtung von elektronischen Elementen in einem Reaktionsrohr kommt es in bekannten Vorrichtungen zur Verunreinigung bzw. ungleichmäßigen Beschichtung der Elemente durch die Ablagerung des Beschichtungsmaterials auf der Innenoberfläche des Reaktionsrohres. Die Beschichtung wird im Chargenbetrieb durchgeführt, und zwischen den einzelnen Beschichtungsvorgängen kühlt das Reaktionsrohr aus, wobei das abgelagerte Material locker wird. Beim darauf folgenden Beschichtungsvorgang können lose Partikel auf die Oberfläche des zu beschichtenden Elements gelangen.

Die Aufgabe der Erfindung ist es, eine Beschichtungs-Vorrichtung und ein Verfahren anzugeben, Welche die Verunreinigung der elektronischen Elemente durch Restablagerungen weitgehend vermindert.

Die Aufgabe der Erfindung wird durch eine Beschichtungs-Vorrichtung nach Anspruch 1 gelöst. Bevorzugte Ausführungsformen sind in den Unteransprüchen enthalten. Die Vorrichtung weist ein Reaktionsrohr mit zwei Endabschlußteilen auf, wobei eine Öffnung zur Beschickung des Reaktionsrohres und ein Anschluß zum Anschließen einer Vakuumleitung an einem Endabschlußteil angeordnet sind, und zumindest ein Gaseinlaß an dem anderen Endabschlußteil des Reaktionsrohres angeordnet ist. Die Vakuumleitung wird an dem Endabschlußteil mit Beschickungsöffnung für die Halbleiterplatten so angeschlossen, daß das Innere des Reaktionsrohrs durch dieses Endabschlußteil, also beschickungsseitig evakuiert wird; zwischen der Vakuumleitung und dem Inneren des Rohres besteht also über das Endabschlußteil eine Strömungsverbindung.

Gemäß der Erfindung wird weiterhin ein Beschichtungs-Verfahren , wie in den Ansprüchen definiert, zur Verfügung gestellt. Durch eine besondere Anordnung der Gasein- und Auslässe kann die Gasströmung so gerichtet werden, daß die Ablagerungsreste weg von den zu beschichtenden Elementen fortgeführt werden. In einer bevorzugten Ausführungsform werden die Gase kurz vor dem Austritt aus dem Reaktionsrohr durch einen Ringspalt geführt, wodurch sich eine höhere Gasgeschwindigkeit ergibt, und damit eine verbesserte Reinigungsgüte erreicht wird. Dies ist sehr von Vorteil, denn gerade im vorderen Endbereich des Reaktionsrohres bzw. an dem Ende, wo die elektronischen Elemente auf einem sogenannten Boot in das Reaktionsrohr eingeführt werden, sind die Ablagerungen bzw. die Gefahr einer Verunreinigung sehr problematisch.

Eine weitere Aufgabe der Erfindung ist es, eine integrierte Reinigungs-Vorrichtung und ein Verfahren anzugeben, welche die Entfernung von Ablagerungsresten von den inneren Oberflächen des Reaktionsrohres bzw. Reaktionsraumes ermöglichen, und zwar zwischen zwei Beschichtungsvorgängen.

Die weitere Aufgabe der Erfindung wird durch die Reinigungs-Vorrichtung, wie sie in den Ansprüchen definiert ist, gelöst. Ein Hohlraumresonator mit Mikrowellengenerator ist an dem hinteren Endabschlußteil des Reaktionsrohres angeschlossen und über ein Gasversorgungssystem mit Reinigungsgas versorgt.

Gemäß der Erfindung wird außerdem ein Verfahren zur Reinigung einer Beschichtungseinrichtung zur Verfügung gestellt, wie es in den Ansprüchen definiert ist. Durch Erzeugen eines Plasmas mit Mikrowellen in dem Hohlraumresonator und die Einleitung des Plasmas in dem Reaktionsraum werden alle Ablagerungsflächen innerhalb dieses Volumens durch trockenes Ätzen gereinigt. Alle Innenoberflächen werden durch diesen Reinigungsprozeß erfaßt, d.h. die Innenoberfläche des Reaktionsrohres, die Innenflächen der Endabschlußteile des Reaktionsrohres und sogar die Oberflächen des Bootes, das zum Zweck der Reinigung in dem Reaktionsrohr ohne elektronische Elemente eingefahren wird. Dieses Verfahren hat auch den Vorteil, daß ein Reinigungsvorgang zwischen zwei Beschichtungsvorgängen durchgeführt werden kann, ohne jeglichen Abbau oder Umbauarbeiten an der Beschichtungseinrichtung. Somit ist ein in situ Reinigungsverfahren geschaffen, das vollständig in den Produktionsablauf integriert ist und sich durch die dabei gewonnenen Zeitersparnisse günstig auf die Produktionskapazität auswirkt.

Die bevorzugte Ausführungsform der Beschichtungseinrichtung gemäß der Erfindung weist sowohl die Anordnung der Gaszufuhr und des Vakuumanschlusses (wie definiert) auf, als auch die Reinigungsvorrichtung mit dem Plasma (wie definiert) auf. Besonders bevorzugt ist es, wenn die Plasma-Reinigungseinrichtung an demselben Ende des Reaktionsrohrs angeschlossen, an dem die Gaszufuhr angeschlossen ist, nämlich an dem zu dem Beschickungsende entgegengesetzten bzw. zu diesem gegenüberliegenden Ende.

Weitere Vorteile und Merkmale der Erfindung werden in der nachfolgenden Beschreibung der Ausführungsformen in Verbindungen mit der Zeichnung näher erläutert.

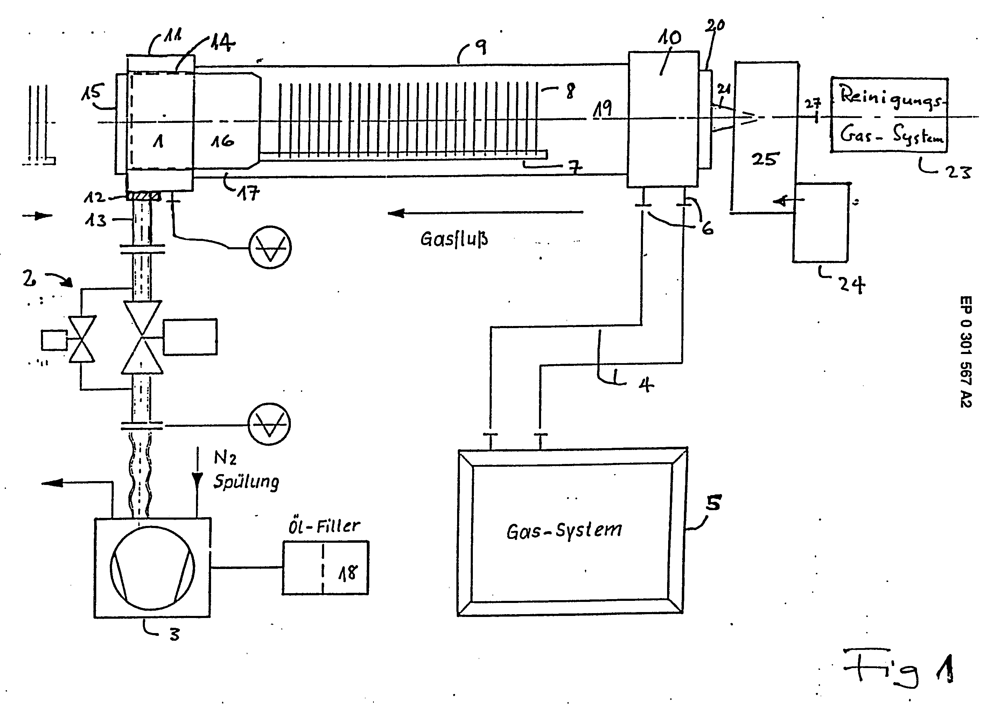

Fig. 1 zeigt eine schematische Darstellung für die Beschichtungs- und Reinigungseinrichtung nach der Erfindung.

Die Beschichtungsvorrichtung in Fig. 1 weist eine Reaktionsraum bzw. -kammer, eine Gasversorgungs- Einrichtung und eine Evakuier-Einrichtung auf. Der Reaktionsraum ist mit einem Reaktionsrohr 9 und zwei Endabschlußteilen 10 und 11 ausgebildet. Die Beschichtungseinrichtung ist in Fig. 1 im beladenen Zustand gezeigt, wobei das Boot 7 die zu beschichtenden Elemente 8, wie z.B. Wafers, Leiterplatten oder ähnliche elektronische Bauteile trägt.

Das Endstück des Bootes 7 weist ein Halterungsteil 1 auf, das beim Einführen des Bootes im Reaktionsrohr 9 in Gleitkontakt mit der Öffnung 14 in dem vorderen Endabschlußteil 11 bleibt, wobei das Boot im beladenen bzw. Betriebsstand gehalten wird. Das Endstück des Bootes weist weiterhin einen zylinderförmigen Abschnitt 16 auf mit einem Durchmesser kleiner als der Innendurchmesser des Reaktionsrohres 9, wodurch ein Ringspalt 17 gebildet wird.

Die Gasversorgungs-Einrichtung weist ein Versorgungssystem 5, zumindest eine Zuführleitung 4 und zumindest einen Gaseinlaß 6 auf. Die Zuführleitungen 4 besitzen separate Steuereinrichtungen, so daß unterschiedliche Gase mit unterschiedlichem Druck in das Reaktionsrohr 9 eingelassen werden können. Die Gaseinlässe 6 sind an dem Endabschlußteil 10 angebracht und somit können unterschiedliche Gase erst beim Eintritt im Reaktionsrohr 9 gemischt werden, wenn dies vom Prozeß her erforderlich ist.

Der vordere Endbereich des Reaktionsrohres 9 ist mit einem Endabschlußteil 11 abgeschlossen, und weist, wie erwähnt, eine Öffnung 14 zur Aufnahme des Bootes 7 auf, sowie einen Verschluß 15. Der Verschluß 15 schließt den Reaktionsraum luftdicht ab und kann mit einfachen Mitteln auf-und-zu gemacht werden zur Be- und Endladung von zu beschichtenden Elementen.

Das Endabschlußteil 11 weist außerdem einen Anschluß 12 auf, der über der Vakuumleitung 13 die Verbindung zur Evakuier-Einrichtung herstellt.

Die Evakuier- Einrichtung weist eine Drucksteuerung 2 in der Vakuumleitung 13, eine Vakuumpumpe 3 und einen Ölfilter 18 auf.

In dieser bevorzugten Ausführungsform der Erfindung, wird der Reaktionsraum 19 über das hintere Endabschlußteil 10 mit Gas versorgt und über das vordere Endabschlußteil 11 evakuiert, wobei eine Gasströmungsrichtung nach vorne einstellt, wie in Fig. 1 mit einem Pfeil angezeigt. Hinsichtlich der unerwünschten Ablagerungen bzw. Reste von Beschichtungsmaterial aus vorhergehenden Beschichtungsvorgängen, die häufig in dem vorderen Bereich des Reaktionsraumes auftreten, hat die bevorzugte Ausführung den Vorteil, daß lose Ablagerungsreste von den Innenwänden des Reaktionsraumes 19 durch die Gasströmung weg von den elektronischen Elementen geführt werden. Somit ist der Grad eine Verunreinigung während des Beschichtungsprozesses wesentlich vermindert.

In Fig. 1 ist außerdem eine Reinigungseinrichtung gezeigt, die baulich und verfahrenstechnisch vollständig in einer Beschichtungseinrichtung integriert werden kann. Ein Hohlraumresonator 25 mit Mikrowellengenerator 24 wird im hinteren Endbereich des Reaktionsraumes 19 am Endabschlußteil 10 angeschlossen. Ein Reinigungsgas-Versorgungssystem 23 speist den Hohlraumresonator 25 mit Reinigungsgas über den Anschluß 27. In einer bevorzugten Ausführungsform der Erfindung wird ein halogen-haltiges, insbesondere fluor-haltiges Ätzgas verwendet.

Das in dem Hohlraumresonator erzeugte Plasma wird direkt in den Reaktionsraum 19 eingeführt und reinigt die Innenflächen des Reaktionsrohres 9 und der Endabschlußteile 10, 11, sowie die Oberflächen des Bootes 7 (ohne elektronischen Elementen) einschließlich des zylindrischen Abschnitts 16. In der bevorzugten Ausführung der Erfindung, werden die Innenflächen gereinigt bzw. trocken geätzt mit $F^-$ Ionen aus dem Plasma. Die gasförmigen Reinigungsprodukte werden im vorderen Endbereich des Reaktionsraumes 19 über die oben erwähnte Evakuier-Einrichtung abgeführt. Die Reinigungsprodukte gelangen letztlich ins Öl der Vakuumpumpe 3. Eine Ölreinigung mit dem Ölfilter 18 ist vorgesehen.

Nachdem die Verunreinigungen des Reaktionsraumes häufig im vorderen Endbereich des Reaktionsrohres 9 und auf dem Endabschlußteil 11 auftreten, ist der Abschnitt 16 des Bootes 7 in einer bevorzugten Ausführung des Erfindung so ausgestaltet, daß ein Ringspalt 17 zwischen dem Abschnitt 16 und dem Reaktionsrohr 9 gebildet wird. Diese Verengung des Gasströmungsquerschnitts führt zu höheren Gasgeschwindigkeiten im vorderen Endbereich des Reaktionsraumes und somit zu einem verbesserten Reinigungseffekt.

Die Reinigungs-Einrichtung hat den großen Vorteil, daß sie direkt an eine bestehende Beschichtungseinrichtung angeschlossen ist und der Produktionsablauf, nämlich die Beschichtung von elektronischen Elementen, nur unwesentlich gestört wird. Das heißt, der Reinigungsvorgang kann zwischen zwei Beschichtungsvorgängen eingeschoben werden, und es ist nicht erforderlich, etwa das Reaktionsrohr abzubauen und die Reinigung am anderen Ort durchzuführen.

**Ansprüche**

1. Vorrichtung zur Behandlung von Materialoberflächen, insbesondere zur Beschichtung von elektronischen Wafers, Leiterplatten und dergleichen durch die thermische Zersetzung eines Gases in einem evakuierten Reaktionsrohr,

**dadurch gekennzeichnet,**

daß das Reaktionsrohr (9) zwei Endabschlußteile aufweist, ein hinteres Endabschlußteil (10) mit zumindestens einem Gaseinlaß (6) im hinteren Endbereich des Reaktionsrohres und ein vorderes Endabschlußteil (11) im vorderen Endbereich des Reaktionsrohres, daß ein Anschluß (12) zum Anschließen einer Vakuumleitung (13) im vorderen Endbereich des Reaktionsrohres (9) vorgesehen ist, daß das vordere Endabschlußteil (11) eine Öffnung (14) zur Beschickung des Reaktionsrohres und einen luftdichten Verschluß (15) zum Verschließen der Öffnung (14) aufweist.

2. Vorrichtung nach Anspruch 1, dadurch gekennzeichnet, daß das Reaktionsrohr (9) ein Quarzrohr ist.

3. Vorrichtung nach Anspruch 1, dadurch gekennzeichnet, daß der Gaseinlaß (6) über zumindest eine Zuführleitung (4) mit einem Gasversorgungssystem (5) verbunden ist, welches eine separate Mengen- und Drucksteuerung für jede Zuführleitung aufweist.

4. Vorrichtung nach Anspruch 1, dadurch gekennzeichnet, daß im Reaktionsrohr bei dessen vorderen Ende ein Halterungsteil (1) schwebend, ohne Kontakt mit der Innenfläche des Reaktionsrohres, angeordnet ist, und ein Boot (7) in Betriebsposition hält.

5. Vorrichtung nach Anspruch 1, dadurch gekennzeichnet, daß das Halterungsteil (1) einen zylinderförmigen Abschnitt (16) aufweist mit einem Durchmesser kleiner als der Innendurchmesser des Reaktionsrohres (9), wodurch ein Ringspalt (17) zwischen dem Abschnitt (16) und dem Reaktionsrohr (9) gebildet wird.

6. Vorrichtung nach einem der vorhergehenden Ansprüche, gekennzeichnet durch eine mit dem Ausschluß (12) am vorderen Endbereich des Reaktionsrohres verbundene Evakuier-Einrichtung (2,3).

7. Verfahren zur Behandlung von Materialoberflächen, insbesondere Beschichtung von elektronischen Elementen wie Wafers, Leiterplatten oder dergleichen, dadurch gekennzeichnet

- daß ein Reaktionsrohr (9) durch eine vordere Öffnung (14) mit zu beschichtenden, auf einem Boot (7) angeordneten Elementen (8) beladen wird,

- daß das vordere Ende des Reaktionsrohres (9) mit einem Verschluß (15) luftdicht abgeschlossen wird,

- daß das Reaktionsrohr über einen Anschluß (12) im vorderen Endbereich des Reaktionsrohres evakuiert und auf einem vorbestimmten Unterdruck gehalten wird,

- daß Gas aus einem Gasversorgungssystem (5) durch zumindest eine Zuführleitung (4) über zumindest einen Gaseinlaß (6) in dem hinteren Endbereich des Reaktionsrohres (9) eingeführt wird, wobei sich eine Gasströmung im Reaktionsrohr vom hinteren Endbereich in Richtung zum vorderen Endbereich des Reaktionsrohres einstellt,

- daß im Reaktionsrohr strömendes Gas bis zur Zersetzungstemperatur des Gases erhitzt wird, und Zersetzungsprodukte mit den Elementen in Kontakt gebracht, insbesondere auf die Elemente abgelagert werden,

- daß der Einlaß (6) und der Anschluß (12) nach Beendigung des Beschichtungsbetriebes geschlossen werden, der Verschluß (15) geöffnet wird und die behandelten Elemente entfernt werden.

8. Verfahren nach einem der Ansprüche 7, dadurch gekennzeichnet, daß eine Vorrichtung nach einem der Ansprüche 1 bis 6 verwendet wird.

9. Verfahren nach Anspruch 8, dadurch gekennzeichnet, daß die Strömungsgeschwindigkeit des Gases beim Austritt aus dem Reaktionsrohr (9) durch den Ringspalt (17) höher liegt als die Strömungsgeschwindigkeit in den anderen Bereichen des Reaktionsrohres.

10. Vorrichtung zur Behandlung von Materialoberflächen, insbesondere zur Beschichtung von elektronischen Elementen wie Wafers, Leiterplatten oder dergleichen, dadurch gekennzeichnet, daß eine Reinigungseinrichtung an einem Endabschlußteil (10) im hinteren Endbereich eines Reaktionsrohres (9) angeschlossen ist, die einen Hohlraum-Resonator (25) mit einem Mikrowellen-Generator (24) aufweist, wobei sich der Hohlraum-Resonator dem Endabschlußteil (10) anschließt und einen Anschluß (27) zur Einführung eines Reinigungsgases aufweist, der mit einer Quelle für Reinigungsgas verbunden ist.

11. Vorrichtung nach Anspruch 10, dadurch gekennzeichnet, daß der Hohlraum-Resonator (25) über ein Verbindungselement (20) und einen Reinigungsgas-Einlaß (21) mit dem Endabschlußteil (10) verbunden ist.

12. Vorrichtung nach Anspruch 10, dadurch gekennzeichnet, daß der Hohlraum-Resonator (25) über den Anschluß (27) mit einem Reinigungsgas-Versorgungssystem (23) in Verbindung steht, das einen Behälter mit halogenhaltigem, insbesondere fluorhaltigem Reinigungsgas aufweist.

13. Vorrichtung nach Anspruch 10, dadurch gekennzeichnet, daß das Reinigungsgas-Versorgungssystem (23) eine Mengen- bzw. Drucksteuerung aufweist, zur Steuerung der Reinigungsgas-Zufuhr.

14. Vorrichtung nach Anspruch 10, dadurch gekennzeichnet, daß das Verbindungselement (20) ein Ventil aufweist, um im Beschichtungs-Betrieb das Reaktionsrohr (9) von dem Reinigungsgas-Einlaß (21) luftdicht zu trennen.

15. Verfahren zur Reinigung einer Beschichtungseinrichtung für elektronischen Elemente, dadurch gekennzeichnet, daß
- ein mit zu reinigendes Boot (7) ohne Elemente in einem Reaktionsrohr (9) eingeführt wird,
- das vordere Ende des Reaktionsrohres (9) mit einem Verschluß (15) luftdicht abgeschlossen wird,
- am hinteren Ende des Reaktionsrohres (9) angeordnete Gaseinlässe (6) abgesperrt werden,
- das Reaktionsrohr (9) über einen Anschluß (12) evakuiert und auf einem vorbestimmten Unterdruck gehalten wird,
- ein Ventil in einem Verbindungselement (20) geöffnet wird,
- ein Mikrowellen-Generator (24) in Betrieb gesetzt wird,
- ein Reinigungsgas aus einem Reinigungsgas-Versorgungssystem (23) in einem Hohlraum-Resonator (25) eingelassen wird,
- das Reinigungsgas in dem Hohlraum-Resonator (25) ionisiert und über einem Endabschlußteil (10) im hinteren Endbereich des Reaktionsrohres (9), dem Reaktionsrohr zugeführt wird,
- die Innenoberfläche des Reaktionsrohres, die Innenseiten des hinteren Endabschlußteiles (10) und eines vorderen Endabschlußteiles (11) und die Außenoberflächen des Bootes (7) durch Einwirkung des ionisierten Reinigungsgases gereinigt werden,
- die Reinigungsabgase im vorderen Endbereich des Reaktionsrohres abgeleitet werden.

16. Verfahren nach Anspruch 15, dadurch gekennzeichnet, daß als Reinigungsgas ein halogenhaltiges, insbesondere fluorhaltiges Gas eingesetzt wird.

17. Verfahren nach Anspruch 15, dadurch gekennzeichnet, daß mit dem Anschluß (12) eine Evakuier-Einrichtung (2,3) verbunden ist, deren Ölkreis mit einem Öl-Filter (18) gereinigt wird.

Gasfluß

N₂
Spülung

Öl-Filler

Gas-System

Reinigungs-Gas-System

Fig 1

EP 0 301 567 A2